# EUROPEAN PATENT SPECIFICATION

(11) **EP 0 477 683 B1**
(45) Date of publication and mention of the grant of the patent: **22.07.1998**
(21) Application number: 91115448.2
(22) Date of filing: 12.09.1991
(51) Int. Cl.: H01L 21/82

(54) **BiCMOS Structure fabrication**
Verfahren zum Herstellen einer BiCMOS Struktur
Procédé de fabrication d'une structure du type BiCMOS

(30) Priority: 27.09.1990 US 588867
(43) Date of publication of application: 01.04.1992
(73) Proprietor: MOTOROLA, INC., Schaumburg, IL 60196 (US)
(72) Inventor: Zdebel, Peter J., W-8193 St. Heinrich (DE)
(74) Representative: Dunlop, Hugh Christopher

(56) References cited:
- EP-A- 0 215 583
- EP-A- 0 364 818
- EP-A- 0 424 298
- IEEE Electron Device Meeting, Los Angeles, 7-10 December 1986, pages 252-255
- IEEE Electron Device Meeting 1984, Technical Digest, pages 761-764

## Description

### Background of the Invention

This invention relates, in general, to semiconductor devices, and more particularly to the fabrication of CMOS devices which may be integrated into a BICMOS process.

A major trend in the semiconductor art is towards the fabrication of circuits integrating devices of multiple technologies. For example, a BICMOS integrated circuit which contains both bipolar and CMOS devices is highly desirable because the best characteristics of both technologies may be obtained and superior high performance integrated circuits may be fabricated.

There have been many problems associated with the integration of bipolar and CMOS devices into a single circuit. It is generally impractical to fabricate CMOS devices in a traditionally bipolar structure and vice versa. Many attempts at doing so have resulted in circuits having poor performance and requiring large amounts of real estate. Accordingly, the practical fabrication of BICMOS integrated circuits must have process integration flexibility as well as enhanced scalability characteristics.

European Patent Application EP-A-0 215 583, entitled "BIPOLAR AND/OR MOS DEVICES FABRICATED ON INTEGRATED CIRCUIT SUBSTRATES"; Hillenius et als. paper entitled "A Symmetric Submicron CMOS Techology", published in IEDM in 1986; and Alvarez et als. paper entitled "2 MICRON MERGED BIPOLAR-CMOS TECHNOLOGY", published in IEDM in 1984 give examples of merged CMOS and bipolar circuits.

In view of the above, it would be highly desirable to have a method of fabricating a CMOS structure that could be easily integrated into a BICMOS process.

### Summary of the Invention

Accordingly, it is an object of the present invention to provide a method of fabricating a CMOS structure that may be integrated into a BICMOS process.

Another object of this invention is to provide a method of fabricating a CMOS structure having process integration flexibility.

It is an additional object of the present invention to provide a method of fabricating a CMOS structure having excellent scalability characteristics.

In accordance with the present invention there is provided a method of integrating CMOS devices into a BiCMOS structure comprising the steps of:
providing a monocrystalline silicon substrate having thereon at least one epitaxial silicon layer, a plurality of filled isolation trenches extending into said substrate, field oxide regions disposed on the surface of said at least one epitaxial layer defining a plurality of active device regions disposed between said field oxide regions;
implanting dopant into at least some of said plurality of active device regions to form doped wells, at least one doped well having an N conductivity type and at least one doped well having a P conductivity type;
depositing a first conformal nitride layer on the surface of the structure;
removing portions of said first conformal nitride layer from above some of said doped wells;
growing a gate oxide layer on said doped wells where said portions of said first conformal nitride layer were formerly disposed;
depositing a first conformal polysilicon layer on the surface of the structure;
performing threshold implants into some of said doped wells through said first conformal polysilicon layer and said gate oxide layer;
depositing a second conformal polysilicon layer on said first conformal polysilicon layer;
doping said first and second conformal polysilicon layers to have a P conductivity type where disposed above said at least one N doped well and an N conductivity type where disposed above said at least one P doped well, wherein the doping said first and second conformal polysilicon layers step further includes doping said first and second conformal polysilicon layers in the regions disposed over active device regions to have bipolar devices formed therein;
etching gate electrodes from said first and second doped conformal polysilicon layers;
implanting first portions of source and drain regions in said doped wells, the implant being self-aligned to said gate electrodes;
forming dielectric spacers abutting the edges of said gate electrodes;
implanting second portions of said source and drain regions, the implant being self-aligned to said dielectric spacers;
depositing a second conformal nitride layer on the surface of the structure including said gate electrodes and said dielectric spacers;
depositing a conformal oxide layer on said second conformal nitride layer;
planarizing said conformal oxide layer;
fabricating an emitter-base structure in at least some of active device regions to have bipolar devices formed therein; and
forming source and drain contacts.

### Brief Description of the Drawings

FIG. 1 is a highly enlarged cross-sectional view of a portion of an isolation module of the type to be used in conjunction with the present invention; and
FIGS. 2-4 are highly enlarged cross-sectional views of a portion of a CMOS structure during processing.

### Detailed Description of the Invention

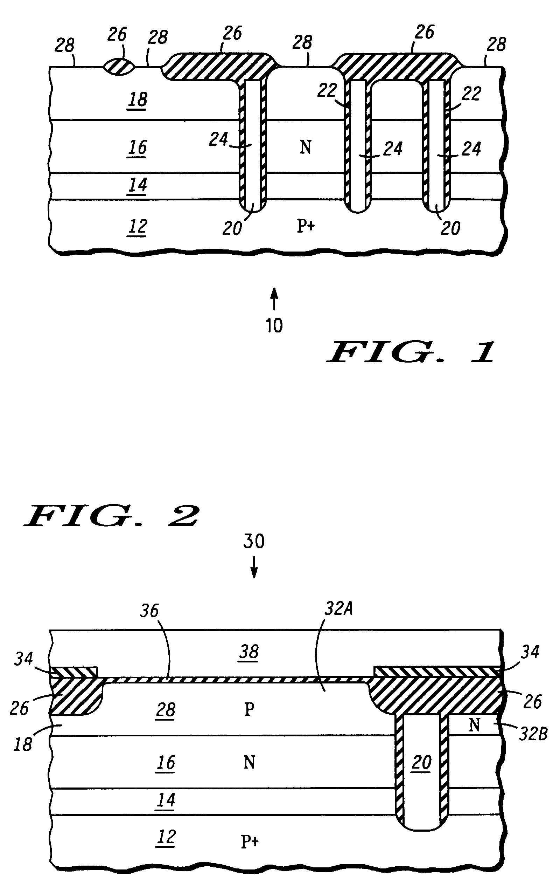

FIG. 1 is a highly enlarged cross-sectional view of an isolation module 10 of the type to be used in conjunction with the present invention. Although isolation module 10 as depicted herein comprises specific materials, conductivity types and dopant concentrations, it should be understood that these may vary. The fabrication of isolation module 10 may be in accordance with the method disclosed and taught by U. S. Patent No. 4,994,406 entitled "Method of Fabricating Semiconductor Devices Having Deep and Shallow Isolation Structures" filed on November 3, 1989 and issued on February 19, 1991 to B. Vasquez and P. Zdebel. It should be understood that the invention may also be employed with other type isolation modules or structures.

Isolation module 10 comprises a monocrystalline silicon substrate 12 having a P+ conductivity type and a dopant concentration of approximately 2 x 10¹⁶ to 2 x 10¹⁷ atoms/cm³. An epitaxial silicon layer 14 is formed on substrate 12. Epitaxial layer 14 may be either N type or P type and in this embodiment, has a relatively low dopant concentration on the order of 1 x 10¹⁴ atoms/cm³. A maskless buried layer 16 is formed on epitaxial silicon layer 14. Buried layer 16 comprises epitaxial silicon, has an N conductivity type and a peak dopant concentration on the order of 3 x 10¹⁹ to 4 x 10¹⁹ atoms/cm³. An epitaxial silicon layer 18 is formed on buried layer 16. Epitaxial layer 18 is approximately one micron thick, may be either N type or P type and has a dopant concentration on the order of 5 x 10¹⁵ atoms/cm³. Generally, active devices will be formed in epitaxial layer 18 of isolation module 10.

A plurality of isolation trenches 20 are formed through epitaxial layer 18, buried layer 16, epitaxial layer 14 and extend into substrate 12. Trenches 20 are lined with a trench liner oxide 22 and filled with polysilicon 24. Field oxide regions 26 are formed on the surface of isolation module 10 and with isolation tenches 20, generally separate and insulate active device regions 28 where the semiconductor devices will be formed.

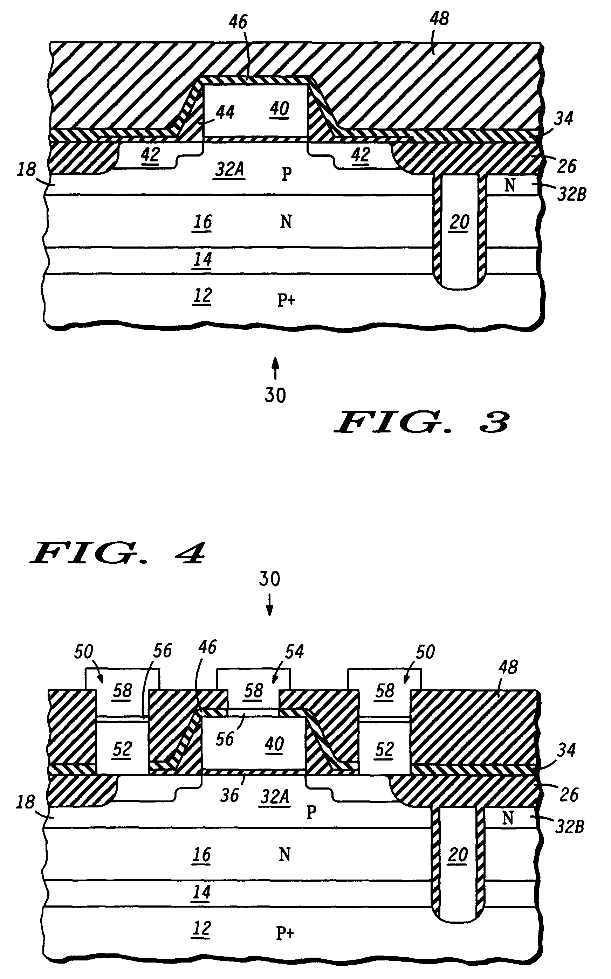

FIGs. 2-4 are highly enlarged cross-sectional views of a portion of a CMOS transistor structure 30 during fabrication in accordance with the present invention. Although the fabrication of basically only a single transistor is depicted by these FIGs., it should be understood that the present invention is intended to fabricate CMOS structures and more specifically, integrating a CMOS process into a BICMOS process flow.

Now referring specifically to FIG. 2. After forming a screen oxide layer (not shown) on active device regions 28, epitaxial silicon layer 18 of active device regions 28 is doped to form doped wells 32. A P doped well 32A is formed by implanting a P type dopant such as boron into epitaxial silicon layer 18 of active device region 28. This will allow for the formation of an N channel device. An N doped well 32B is then formed by implanting an N type dopant such as phosphorous into epitaxial silicon layer 18 of other active device regions 28 where P channel devices are desired. Doped wells 32 may be formed by either a single implant or by multiple implants with staged energies and implant doses. Doped wells 32 may either be driven simultaneously or separately between implanting P type and N type dopants. Optimally, the surface concentration of P doped well 32A will be on the order of 5 x 10¹⁶ atoms/cm³ and the surface concentration of N doped well 32B will be on the order of 8 x 10¹⁶ atoms/cm³.

Following the formation of doped wells 32, a first conformal nitride layer 34 is deposited over the entire surface of structure 30. It should be understood that first conformal nitride layer 34 is deposited over the entire surface of isolation module 10 (see FIG. 1) in a BICMOS process flow. In a preferred embodiment, first conformal nitride layer 34 will have a thickness of approximately 500 angstroms (1 Angstrom = 10⁻¹⁰ m). After its formation, first conformal nitride layer 34 is masked and its portions disposed above doped wells 32 are etched from the surface of structure 30. The mask should slightly overlap onto field oxide regions 26 so that they become partially exposed after the portions of first conformal nitride layer 34 are etched away.

Once first conformal nitride layer 34 has been etched as desired, the screen oxide layer (not shown) is removed from above doped wells 32. This oxide etch may be performed by many methods well known in the art although a wet etch employing hydrofluoric acid is preferably employed. Following the removal of the screen oxide layer (not shown), a gate oxide layer 36 having a thickness in the range of 100 to 150 angstroms is grown over doped wells 32. Gate oxide layer 36 is thermally grown in this embodiment although it may be formed by other methods.

After the formation of gate oxide layer 36, a conformal polysilicon layer 38 is formed on the surface of structure 30. It should be understood that in the entire BICMOS process, conformal polysilicon layer 38 would be formed over the entire surface of isolation module 10 (See FIG. 1). Initially, a first portion of conformal polysilicon layer 38 comprising approximately 500 angstroms is formed immediately after the formation of gate oxide layer 36. This first portion of conformal polysilicon layer 38 satisfies boundry states. Threshold implants are then performed through the first portion of conformal polysilicon layer 38 and gate oxide layer 36 into doped wells 32. Once these threshold implants have been performed, additional polysilicon is formed on conformal polysilicon layer 38 so that its total thickness is approximately 3000 angstroms. It should be understood that conformal polysilicon layer 38 will form the resistors and base electrodes of bipolar devices fabricated by the BICMOS process as well as the CMOS gate electrodes which will be explained presently.

Now referring specifically to FIG. 3. Conformal polysilicon layer 38 is doped following its formation. In MOS structure 30, the portions of conformal polysilicon layer 38 which will become gate electrodes are appropriately doped. In the entire BICMOS process flow, the portions of conformal polysilicon layer 38 which will become the resistors and base electrodes in the bipolar devices are also appropriately doped at this time. Conformal polysilicon layer 38 is masked and etched following its doping. On MOS structure 30, a doped gate electrode 40 is formed from conformal polysilicon layer 38. Doped resistors and base electrodes are formed by etching conformal polysilicon layer 38 in the bipolar regions of isolation module 10 (see FIG. 1). The etching of conformal polysilicon layer 38 is preferably performed by reactive ion etching although other types of etching may be employed.

Once gate electrode 40 has been etched from conformal polysilicon layer 38, source and drain regions 42 which are interchangeable in this structure are formed. Initially, first portions of source and drain regions 42 are implanted. The implant is self-aligned to gate electrode 40. Following the implantation of the first portions of source and drain regions 42, sidewall spacers 44 abutting gate electrode 40 are formed. The formation of spacers 44 is consistent with methods well known in the art including the formation of a conformal oxide or nitride layer in a low temperature deposition process such as PECVD from which spacers 44 are etched. The formation of spacers 44 may be done simultaneously with the formation of spacers abutting the resistors and base electrodes of the bipolar devices in a BICMOS process flow. Once sidewall spacers 44 have been formed abutting gate electrode 40, second portions of source and drain regions 42 are implanted. This implant is self-aligned to sidewall spacers 44.

The device depicted in structure 30 will comprise N type source and drain regions 42 because doped well 32A is P type. N type source and drain regions 42 are formed by implanting arsenic or another N dopant into doped well 32A as described above. In an MOS device where doped well 32 is of an N conductivity type, source and drain regions 42 would be of a P conductivity type and formed by implanting boron or another P type dopant.

Following the formation of source and drain regions 42, a conformal nitride layer 46 is formed on the surface of structure 30. Conformal nitride layer 46 is approximately 500 angstroms thick and forms an ion contamination barrier over structure 30. A low temperature oxide layer 48 is then deposited on nitride layer 46 over the entire surface of structure 30. Once deposited, oxide layer 48 is then planarized over gate regions 40. A maskless planarizing etch is employed in this embodiment.

After the deposition and planarization of oxide layer 48, the fabrication of the emitter-base structure of the bipolar device is the next step to occur in the BICMOS process. The fabrication of the emitter-base structure is set forth in U.S. Patent No. 5,026,663 entitled "Method of Fabricating a Structure Having Self-Aligned Diffused Junctions" filed on July 21, 1989 and issued June 25, 1991 to P. Zdebel and B. Vasquez.

Now refering specifically to FIG. 4. Once the bipolar emitter-base structure has been fabricated, source and drain contacts are formed for the CMOS devices. Initially, source and drain contact openings 50 are formed through oxide layer 48, nitride layers 46 and 34 and gate oxide layer 36. The openings extend to epitaxial silicon layer 18. Source and drain contact openings 50 are formed simultaneously with collector contact openings for the bipolar devices in the BICMOS process. Once openings 50 have been etched, they are filled with contact polysilicon 52 which is planarized and recessed so that the top surface of polysilicon 52 is below the top surface of oxide layer 48. Where contact polysilicon 52 is formed to contact source and drain regions 42 of a device having a P type doped well 32A, it will be doped with an N type dopant such as arsenic. Where contact polysilicon 52 contacts the source and drain regions of a device having an N type doped well 32B it will be doped with a P type dopant such as boron. If contact polysilicon 52 is desired to contact doped wells 32A and 32B, its conductivity type must be the same as the well it contacts. It should be understood that the formation of contact polysilicon 52 is performed simultaneously with the formation of polysilicon to contact the collectors and emitters of the bipolar devices in the BICMOS process.

Once contact polysilicon 52 has been formed and doped, a gate electrode contact opening 54 is formed by etching through oxide layer 48 and nitride layer 46 to expose polysilicon gate electrode 40. In the BICMOS process, contact openings to the polysilicon resistors and base electrodes of the bipolar devices are also formed at this time. Silicide 56 is formed on all exposed polysilicon including gate electrode 40 and contact polysilicon 52 of structure 30 as well as the polysilicon exposed on the bipolar structure. Once silicide 56 has been formed, contact metal 58 is formed on silicide 56. The formation of silicide 56 and contact metal 58 is by methods well known in the art.

## Claims

1. A method of integrating CMOS devices into a BiCMOS structure, comprising the steps of:
providing a monocrystalline silicon substrate (12) having thereon at least one epitaxial silicon layer (14, 16, 18), a plurality of filled isolation trenches (20) extending into said substrate (12), field oxide regions (26) disposed on the surface of said at least one epitaxial layer (14, 16, 18) defining a plurality of active device regions (28) disposed between said field oxide regions (26);
implanting dopant into at least some of said plurality of active device regions (28) to form doped wells (32), at least one doped well (32B) having an N conductivity type and at least one doped well (32A) having a P conductivity type;
depositing a first conformal nitride layer (34) on the surface of the structure;
removing portions of said first conformal nitride layer (34) from above some of said doped wells (32);
growing a gate oxide layer (36) on said doped wells (32) where said portions of said first conformal nitride layer (34) were formerly disposed;
depositing a first conformal polysilicon layer on the surface of the structure;
performing threshold implants into some of said doped wells (32) through said first conformal polysilicon layer and said gate oxide layer (36);
depositing a second conformal polysilicon layer on said first conformal polysilicon layer;
doping said first and second conformal polysilicon layers (38) to have a P conductivity type where disposed above said at least one N doped well (32B) and an N conductivity type where disposed above said at least one P doped well (32A), wherein the doping said first and second conformal polysilicon layers (38) step further includes doping said first and second conformal polysilicon layers (38) in the regions disposed over active device regions (28) to have bipolar devices formed therein;
etching gate electrodes (40) from said first and second doped conformal polysilicon layers (38);
implanting first portions of source and drain regions (42) in said doped wells (32), the implant being self-aligned to said gate electrodes (40);
forming dielectric spacers (44) abutting the edges of said gate electrodes (40);
implanting second portions of said source and drain regions (42), the implant being self-aligned to said dielectric spacers (44);
depositing a second conformal nitride layer (46) on the surface of the structure including said gate electrodes (40) and said dielectric spacers (44);
depositing a conformal oxide layer (48) on said second conformal nitride layer (46);
planarizing said conformal oxide layer (48);
fabricating an emitter-base structure in at least some of active device regions (28) to have bipolar devices formed therein; and
forming source and drain contacts.

2. The method of claim 1 wherein the etching gate electrode (40) step further includes etching resistors and base electrodes for bipolar devices from the first and second doped conformal polysilicon layers (38).

3. The method of claim 2 wherein the forming dielectric spacers (44) step further includes forming dielectric spacers (44) abutting the edges of the resistors and base electrodes of the bipolar devices.

4. The method of claim 3 wherein the forming source and drain contacts step comprises:
forming source and drain contact openings (50) extending to the surface of the at least one epitaxial layer (14, 16, 18);
forming polysilicon (52) in said openings (50) so that the top surface of said polysilicon (52) is recessed below the top surface of the conformal oxide layer (48);
doping said polysilicon (52) in said openings so that said polysilicon (52) disposed over the at least one N doped well (32B) is P type and said polysilicon disposed over the at least one P doped well (32A) is N type;
forming silicide (56) on said polysilicon (52) in said openings; and
forming contact metal (58) on said silicide (56).

5. The method of claim 4 wherein the forming source and drain contact openings (50) step is performed simultaneously with forming collector and emitter contact openings for the bipolar devices.

6. The method of claim 5 wherein the forming polysilicon (52) in said openings is performed simultaneously with forming polysilicon in the collector and emitter openings of the bipolar devices.

7. The method of claim 4 wherein the conformal oxide layer (48) and the second conformal nitride layer (46) are at least locally removed from the surfaces of the gate electrodes (40) as well as the polysilicon resistors and base electrodes of the bipolar devices following the doping said polysilicon step and the forming silicide (56) and forming contact metal (58) steps include forming silicide (56) and contact metal (58) on said gate electrodes (40) of the CMOS devices and said polysilicon resistors and said base electrodes of the bipolar devices.

## Patentansprüche

1. Verfahren zum Integrieren von CMOS-Bauelementen in eine BiMOS-Struktur, das die folgenden Schritte aufweist:
Bereitstellen eines monokristallinen Siliciumsubstrats (12), umfassend wenigstens eine epitaktische Schicht (14, 16, 18) darauf, eine Pluralität von gefüllten Isolationsgräben (20), die sich in das Substrat (12) erstrecken, Feldoxidregionen (26), die auf der Oberfläche der wenigstens einen epitaktischen Schicht (14, 16, 18) angeordnet sind, die eine Mehrzahl von aktiven Bauelementbereichen (28) definieren, die zwischen den Feldoxidregionen (26) angeordnet sind;
Implantieren von Dotiermitteln in wenigstens einigen der Pluralität von aktiven Bauelementbereichen (28), um dotierte Wells (32) zu bilden, wobei wenigstens ein dotierter Well (32B) eine Leitfähigkeit vom Typ N aufweist und wenigstens ein dotierter Well (32A) eine Leitfähigkeit vom Typ P aufweist;
Abscheiden und/oder Aufbringen einer ersten konformen Nitridschicht (34) auf die Oberfläche der Struktur;
Entfernen von Teilen der ersten konformen Nitridschicht (34) von oberhalb einiger der dotierten Wells (32);
Wachsen einer Gate-Oxidschicht (36) auf den dotierten Wells (32), wo die Teile der ersten konformen Nitridschicht (34) vorher angeordnet waren;
Abscheiden und/oder Aufbringen einer ersten konformen Polysiliciumschicht auf die Oberfläche der Struktur;
Ausführen von Schwellenwertimplantierungen in einige der dotierten Wells (32) durch die erste konforme Polysiliciumschicht und die Gate-Oxidschicht (36);
Abscheiden und/oder Aufbringen einer zweiten konformen Polysiliciumschicht auf die erste konforme Polysiliciumschicht;
Dotieren der ersten und zweiten konformen Polysiliciumschicht (38), um eine Leitfähigkeit vom Typ P dort zu erreichen, wo diese über den wenigstens einen N-dotierten Well (32B) angeordnet sind und eine Leitfähigkeit vom Typ N, wo diese über wenigstens einen P-dotierten Well (32A) angeordnet sind, wobei der Dotierungsschritt der ersten und zweiten konformen Polysiliciumschichten (38) außerdem die Dotierung der ersten und zweiten konformen Polysiliciumschicht (38) in den Bereichen beinhaltet, die über den aktiven Bauelementbereichen (28) angeordnet sind, um darin Bipolarbauelemente hergestellt zu haben und/oder herzustellen;
Ätzen von Gate-Elektroden (40) aus den ersten und zweiten dotierten konformen Polysiliciumschichten (38);
Implantieren erster Teile von Source- und Drain-Bereichen (42) in die dotierten Wells (32), wobei das Implantat zu den Gate-Elektroden (40) selbstausgerichtet und/oder selbstjustiert ist;
Herstellen von dielektrischen Spacern (44), die an die Randzonen der Gate-Elektroden (40) grenzen;
Implantieren von zweiten Teilen der Source- und Drain-Bereiche (42), wobei das Implantat zu den dielektrischen Spacern (44) selbstausgerichtet und/oder selbstjustiert ist;
Abscheiden und/oder Aufbringen einer zweiten konformen Nitridschicht (46) auf der Oberfläche der Struktur, die die Gate-Elektroden (40) und die dielektrischen Spacer (44) enthält;
Abscheiden und/oder Aufbringen einer konformen Oxidschicht (48) auf die zweite konforme Nitridschicht (46);
Planarisieren der konformen Nitridschicht (48);
Herstellen einer Emitter-Basisstruktur in wenigstens einigen der aktiven Bauelementbereichen (28), um darin Bipolarbauelemente gebildet zu haben; und
Bilden von Source- und Drain-Kontakten.

2. Verfahren nach Anspruch 1, wobei der Ätzschritt der Gate-Elektrode (40) außerdem das Ätzen von Widerständen und Basis-Elektroden für Bipolarbauelemente aus den ersten und zweiten dotierten konformen Polysiliciumschichten (38) beinhaltet.

3. Verfahren nach Anspruch 2, wobei der Herstellungsschritt der dielektrischen Spacer (44) außerdem die Herstellung von dielektrischen Spacem (44) beinhaltet, die an die Randbereiche der Widerstände und Basiselektroden der Bipolarbauelemente grenzen.

4. Verfahren nach Anspruch 3, wobei der Herstellungsschritt der Source- und Drain-Kontakte umfaßt:
Herstellen von Source- und Drain-Kontaktöffnungen (50), die sich zu der Oberfläche der wenigstens einen epitaktischen Schicht (14, 16, 18) erstrecken;
Bilden und/oder Herstellen von Polysilicium (52) in den Öffnungen (50), so daß die obere Oberfläche des Polysiliciums (52) unter die obere Oberfläche der konformen Oxidschicht (48) ausgespart ist;
Dotieren des Polysiliciums (52) in den Öffnungen, so daß das Polysilicium (52), das über dem wenigstens einen N-dotierten Well (32B) angeordnet ist, vom Typ P ist und das Polysilicium, das über dem wenigstens einen P-dotierten Well (32A) angeordnet ist, vom Typ N ist;
Bilden und/oder Herstellen eines Silizids (56) auf dem Polysilicium (52) in den Öffnungen; und
Bilden und/oder Herstellen von Kontaktmetall (58) auf dem Silizid (56).

5. Verfahren nach Anspruch 4, wobei der Herstellungsschritt der Source- und Drain-Kontaktöffnungen (50) gleichzeitig mit der Herstellung von Kollektor- und Emitterkontaktöffnungen für die Bipolarbauelemente durchgeführt wird.

6. Verfahren nach Anspruch 5, wobei die Herstellung des Polysiliciums (52) in den Öffnungen gleichzeitig mit der Herstellung von Polysilicium in den Kollektor- und Emitteröffnungen der Bipolarbauelemente durchgeführt wird.

7. Verfahren nach Anspruch 4, wobei die konforme Oxidschicht (48) und die zweite konforme Nitridschicht (46) wenigstens lokal sowohl von den Oberflächen der Gate-Elektroden (40) als auch der Polysilicium-Widerstände und Basiselektroden der Bipolarbauelemente entfernt werden, wobei anschließend der Dotierschritt des Polysiliciums und die Schritte des Bildens und/oder Herstellens des Silizids (56) und des Bildens und/oder Herstellens der Kontaktmetalle (58) das Bilden und/oder Herstellen von Silizid (56) und von Kontaktmetall (58) auf den Gate-Elektroden (40) der CMOS-Bauelemente und der Polysilicium-Widerstände und der Basiselektroden auf den Bipolarbauelementen beinhaltet.

## Revendications

1. Procédé d'intégration de dispositifs CMOS dans une structure BICMOS, comprenant les opérations suivantes :
produire un substrat de silicium monocristallin (12) portant au moins une couche de silicium épitaxiale (14, 16, 18), une pluralité de tranchées d'isolation remplies (20) qui s'étendent jusque dans ledit substrat (12), des régions d'oxyde de champ (26) disposées sur la surface de ladite ou desdites couches épitaxiales (14, 16, 18) définissant une pluralité de régions de dispositifs actifs (28) disposées entre lesdites régions d'oxyde de champ (26) ;
implanter un agent de dopage dans au moins certaines régions de ladite pluralité de régions de dispositifs actifs (28) afin de former des puits dopés (32), au moins un puits dopé (32B) ayant un type de conductivité N et au moins un puits dopé (32A) ayant un type de conductivité P ;
déposer une première couche de nitrure conforme (34) sur la surface de la structure ;
retirer, du dessus de certains desdits puits dopés (32), des parties de ladite première couche de nitrure conforme (34) ;
faire croître une couche d'oxyde de grille (36) sur lesdits puits dopés (32) là où lesdites parties de ladite première couche de nitrure conforme (34) étaient antérieurement disposées ;
déposer une première couche de silicium polycristallin conforme sur la surface de la structure ;
effectuer des implantations de seuil dans certains desdits puits dopés (32) au travers de ladite première couche de silicium polycristallin conforme et de ladite couche d'oxyde de grille (36) ;
déposer une deuxième couche de silicium polycristallin conforme sur ladite première couche de silicium polycristallin conforme ;
doper lesdites première et deuxième couches de silicium polycristallin conformes (38) de façon qu'elles aient le type de conductivité P là où elles sont disposées au-dessus dudit ou desdits puits dopés de type N (32B) et le type de conductivité N là où elles sont disposées au-dessus dudit ou desdits puits dopés de type P (32A), où l'opération de dopage desdites première et deuxième couches de silicium polycristallin conformes (38) comporte en outre le dopage desdites première et deuxième couches de silicium polycristallin conformes (38) dans les régions disposées au-dessus de régions de dispositifs actifs (28) afin d'y former des dispositifs bipolaires ;
graver des électrodes de grille (40) à partir desdites première et deuxième couches de silicium polycristallin conformes dopées (38) ;
implanter des premières parties de régions de source et de drain (42) dans lesdits puits dopés (32), l'implantation étant autoalignée sur lesdites électrodes de grille (40) ;
former des éléments d'écartement diélectriques (44) en appui contre les bords desdites électrodes de grille (40) ;
implanter des deuxièmes parties desdites régions de source et de drain (42), l'implantation étant autoalignée sur lesdits éléments d'écartement diélectriques (44) ;
déposer une deuxième couche de nitrure conforme (46) sur la surface de la structure comportant lesdites électrodes de grille (40) et lesdits éléments d'écartement diélectriques (44) ;
déposer une couche d'oxyde conforme (48) sur ladite deuxième couche de nitrure conforme (46) ;
rendre plane ladite couche d'oxyde conforme (48) ;
fabriquer une structure émetteur-base dans au moins certaines des régions de dispositif actifs (28) afin d'y former des dispositifs bipolaires ; et
former des contacts de source et de drain.

2. Procédé selon la revendication 1, où l'opération de gravure d'électrodes de grille (40) comporte en outre la gravure de résistances et d'électrodes de base pour des dispositifs bipolaires à partir desdites première et deuxième couches de silicium polycristallin conformes dopées (38).

3. Procédé selon la revendication 2, où l'opération de formation d'éléments d'écartement diélectriques (44) comporte en outre la formation d'éléments d'écartement diélectriques (44) en appui contre les bords des résistances et des électrodes de base des dispositifs bipolaires.

4. Procédé selon la revendication 3, où l'opération de formation de contacts de source et de drain comprend les opérations suivantes :
former des ouvertures de contact de source et de drain (50) qui s'étendent jusqu'à la surface de ladite ou desdites couches épitaxiales (14, 16, 18) ;
former du silicium polycristallin (52) dans lesdites ouvertures (50) de façon que la surface supérieure dudit silicium polycristallin (52) soit évidée en dessous de la surface supérieure de la couche d'oxyde conforme (48) ;
doper ledit silicium polycristallin (52) se trouvant dans lesdites ouvertures de façon que ledit silicium polycristallin (52) disposé au-dessus dudit ou desdits puits dopés de type N (32B) soit de type P et que ledit silicium polycristallin disposé au-dessus dudit ou desdits puits dopés de type P (32A) soit de type N ;
former du siliciure (56) sur ledit silicium polycristallin (52) se trouvant dans lesdites ouvertures ; et
former un métal de contact (58) sur ledit siliciure (56).

5. Procédé selon la revendication 4, où l'opération de formation d'ouvertures de contact de source et de drain (50) est effectuée en même temps que la formation d'ouvertures de contact de collecteur et d'émetteur pour les transistors bipolaires.

6. Procédé selon la revendication 5, où l'opération de formation de silicium polycristallin (52) dans lesdites ouvertures est effectuée en même temps que la formation de silicium polycristallin dans les ouvertures de collecteur et d'émetteur des dispositifs bipolaires.

7. Procédé selon la revendication 4, où ladite couche d'oxyde conforme (48) et la deuxième couche de nitrure conforme (46) sont au moins localement enlevées des surfaces des électrodes de grille (40) aussi bien que des résistances et des électrodes de base de silicium polycristallin, des dispositifs bipolaires à la suite de l'opération de dopage dudit silicium polycristallin, et les opérations de formation de siliciure (56) et de métal de contact (58) comprennent la formation de siliciure (56) et de métal de contact (58) sur lesdites électrodes de grille (40) des dispositifs CMOS et lesdites résistances et lesdites électrodes de base de silicium polycristallin des dispositifs bipolaires.
